# EUROPEAN PATENT SPECIFICATION

(11) **EP 0 821 385 B1**
(45) Date of publication and mention of the grant of the patent: **16.04.2003**
(21) Application number: 97112387.2
(22) Date of filing: 18.07.1997
(51) Int. Cl.: H01J 17/49, H01J 17/28

(54) **Plasma display device**
Plasmaanzeigevorrichtung
Dispositf d'affichage à plasma

(30) Priority: 23.07.1996 JP 19320496; 16.12.1996 JP 33533496; 24.12.1996 JP 34317396; 14.03.1997 JP 6107697
(43) Date of publication of application: 28.01.1998
(73) Proprietor: MATSUSHITA ELECTRIC INDUSTRIAL CO., LTD., Kadoma-shi, Osaka 571-8501 (JP)
(72) Inventor: Tani, Yutaka, Sanda-shi, Hyogo 669-13 (JP); Hirano, Shigeo, Otsu-shi, Shiga 520 (JP)
(74) Representative: Eisenführ, Speiser & Partner

(56) References cited:
- US-A- 4 546 407
- PATENT ABSTRACTS OF JAPAN vol. 017, no. 480 (E-1425), 31 August 1993 & JP 05 121005 A (NEC CORP), 18 May 1993
- PATENT ABSTRACTS OF JAPAN vol. 097, no. 008, 29 August 1997 & JP 09 097015 A (MATSUSHITA ELECTRIC IND CO LTD), 8 April 1997
- PATENT ABSTRACTS OF JAPAN vol. 016, no. 178 (E-1196), 28 April 1992 & JP 04 022045 A (MATSUSHITA ELECTRON CORP), 27 January 1992

## Description

The present invention generally relates to a plasma display panel (PDP) for displaying characters or images through utilization of gas discharge and more particularly, to a plasma display device which includes a means for efficiently dissipating heat produced by the plasma display panel.

Recently, plasma display devices acting as flat, thin and light display units having a large screen are used for information terminals such as portable computers and their applicable field is expanding due to their clear display and their wide angle of field of view. In a plasma display device, a plasma display panel is formed by front and rear glass plates bonded to each other and gas for electrical discharge is contained in a minute gap between the glass plates. Ultraviolet rays produced by electrical discharge in the gas are irradiated to phosphor on the rear glass plate such that display of light emission from the phosphor is performed. Hence, the plasma display device as a whole reaches rather high temperature through repetition of electrical discharge in the gas.

In a plasma display device, as display luminance of a plasma display panel is raised further, more heat is produced by the plasma display panel, so that temperature of the plasma display panel rises and thus, display performance of the plasma display panel deteriorates. To actuate the plasma display panel for a long time will result in, for example, drop of reliability of a driver circuit for driving the plasma display panel and therefore, is not preferable for performances and properties of the plasma display panel. Meanwhile, if a state in which large difference in temperature exists in a plane of the plasma display panel continues for a long time, glass forming the plasma display panel is distorted, thereby resulting in fracture of the glass.

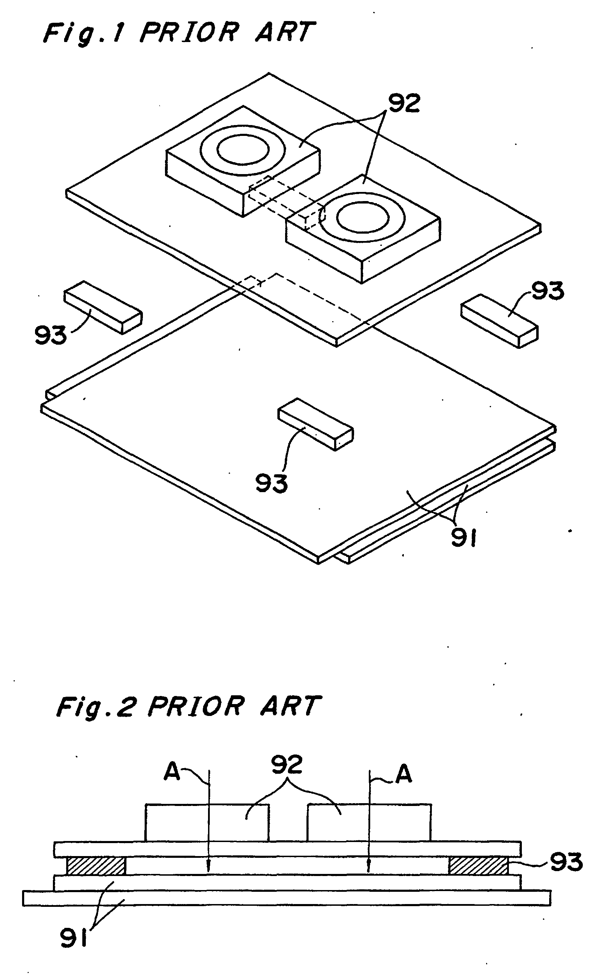

Therefore, in order to lower temperature of the plasma display panel in operation and lessen distortion of the glass leading to its fracture, difference in temperature in the plane of the plasma display panel should be reduced and performances and quality of the plasma display device should be upgraded. As one of such countermeasures in a known plasma display device, a pair of draft fans 92 are provided on a rear face of a plasma display panel 91 through spacers 93 as shown in Fig. 1 and blow wind to the plasma display panel 91 as shown by the arrow A in Fig. 2 so as to lower temperature of the plasma display panel 91.

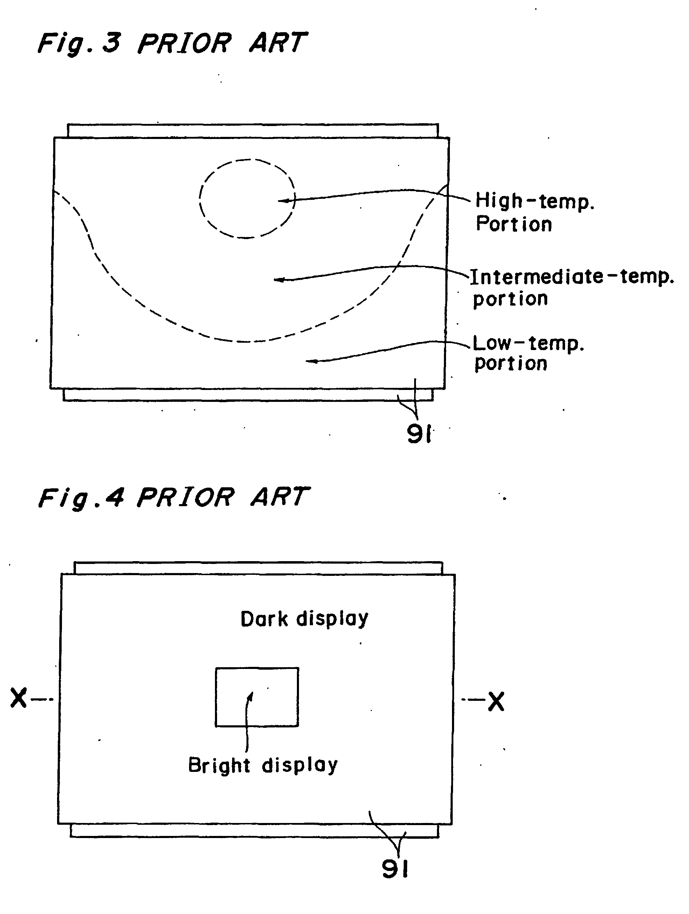

In case the plasma display panel 91 is installed in parallel with a vertical plane, temperature is distributed in a plane of the plasma display panel 91 as shown in Fig. 3 by natural convection of heat and thus, temperature difference between a high-temperature portion and a low-temperature portion reaches 10 plus several °C. Meanwhile, temperature difference in the plane of the plasma display panel 91 increases according to pattern of an image displayed on the plasma display panel 91. For example, if a state in which a small bright image (bright display) is present in a dark background (dark display) as shown in Fig. 4 continues for a long time, temperature difference between the bright image and the dark background increases considerably, so that glass forming the plasma display panel 91 is distorted, thus resulting in fracture of the plasma display panel 91. Especially, if temperature difference in the plane of the plasma display panel 91 reaches 20 °C or more, there is a great risk of fracture of the plasma display panel 91.

In the conventional plasma display device provided with the draft fans 92, temperature of the plasma display panel 91 can be lowered but such a problem arises that it is difficult to reduce temperature difference in the plane of the plasma display panel 91. Furthermore, the prior art plasma display device has such drawbacks that noise of motors for the draft fans 92 is annoying, electric power is required to be supplied for driving the motors for the draft fans 92, the plasma display device as a whole becomes large due to the need for providing space for mounting the motors for the draft fans 92 and dust sucked together with external air into a casing of the plasma display device by the draft fans 92 stains interior of the casing.

Meanwhile, in a known plasma display device, in order to lower temperature of a plasma display panel in operation and upgrade performances and quality of the plasma display device as a whole, it is effective to attach a chassis member to a rear face of the plasma display panel. In this case, it is important that the plasma display panel and the chassis member are brought into close contact with each other.

JP-A-05 121 005 discloses a plasma display panel comprising an air-type container formed between the display surfaces. Heat generated by the plasma display panel during operation warms a cooling water which flows in the container so that a convection current is generated inside the container. The heat of the panel is thereby moved to a metal plate through the cooling water, and the heat is discharged to the open air from a heat sink with the result that the panel is cooled.

### SUMMARY OF THE INVENTION

Accordingly, an essential object of the present invention is to provide, with a view to eliminating the above mentioned disadvantages of prior art, a plasma display device in which even when luminance of a plasma display panel is raised, temperature of the plasma display panel is kept low and high display quality is secured by lessening temperature difference in a plane of the plasma display panel.

In order to accomplish this object of the present invention, a plasma display device according to the present invention is defined in claim 1.

It is preferable that the thermally conductive medium is provided so as to be brought into substantially close contact with the plasma display panel and the chassis member.

It is also preferable that the thermally conductive medium has a two-layer construction having first and second mediums brought into substantially close contact with the plasma display panel and the chassis member, respectively such that not only the first medium has a coefficient of thermal conductivity higher than that of the second medium but the second medium functions also as a cushioning medium.

By the above described arrangements of the plasma display device of the present invention, since heat in a plane of the plasma display panel in operation is conducted to the chassis member through the thermally conductive medium so as to be dissipated into air, temperature in the plane of the plasma display panel can be lowered and temperature difference in the plane of the plasma display panel can be lessened.

Furthermore, close contact of the thermally conductive medium with the plasma display panel and the chassis member can be enhanced by eliminating warpage of the plasma display panel and the chassis member and impact applied to the plasma display device from outside can be mitigated by the second medium functioning also as the cushioning medium.

### BRIEF DESCRIPTION OF THE DRAWINGS

This object and features of the present invention will become apparent from the following description taken in conjunction with the preferred embodiments thereof with reference to the accompanying drawings, in which:
Fig. 1 is an exploded perspective view of a prior art plasma display device (already referred to);
Fig. 2 is a sectional view of the prior art plasma display device of Fig. 1 (already referred to);
Fig. 3 is a schematic view showing temperature distribution in a plane of a plasma display panel of the prior art plasma display device of Fig. 1 (already referred to);
Fig. 4 is a schematic view showing a pattern of display in the plasma display panel (already referred to);
Fig. 5 is an exploded perspective view of a plasma display device;
Fig. 6 is a sectional view of the plasma display device of Fig. 5;
Fig. 7 is a sectional view of a plasma display device;
Fig. 8 is a graph showing characteristics of temperature distribution in plasma display panels of the plasma display devices of Figs. 5 and 7;
Fig. 9 is a sectional view of a plasma display device;
Fig. 10 is a sectional view of a chassis member of the plasma display device of Fig. 9;
Fig. 11 is a top plan view of a heat-resistant cushioning medium of the plasma display device of Fig. 9;
Fig. 12 is a top plan view of the chassis member of Fig. 10 provided with the cushioning medium of Fig. 11;
Fig. 13 is a sectional view of the chassis member and the cushioning medium of Fig. 12;
Fig. 14 is a sectional view showing curing of liquid of a thermally conductive medium of the plasma display device of Fig. 9;
Fig. 15 is a sectional view of a plasma display;
Fig. 16 is a sectional view of a chassis member of the plasma display device of Fig. 15;
Fig. 17 is a top plan view of a mold employed for manufacture of the plasma display device of Fig. 15;
Fig. 18 is a top plan view of the chassis member of Fig. 16 provided with the mold of Fig. 17;
Fig. 19 is a sectional view of the chassis member and the mold of Fig. 18;
Fig. 20 is a sectional view showing curing of liquid of a thermally conductive medium of the plasma display device of Fig. 15;
Fig. 21 is an exploded perspective view of a plasma display device according to the present invention;
Fig. 22 is a perspective view of a chassis member of the plasma display device of Fig. 21;
Fig. 23 is a fragmentary sectional view of the plasma display device of Fig. 21;
Fig. 24 is a fragmentary perspective of a plasma display device which is a modification of the plasma display device of Fig. 21;
Fig. 25 is an exploded perspective view of a plasma display device according to an embodiment of the present invention;
Fig. 26 is a top plan view of a sheet piece forming a thermally conductive sheet of the plasma display device of Fig. 25;
Fig. 27 is a side elevational view of the sheet piece of Fig. 26;
Fig. 28 is a view explanatory of a step for assembling a plasma display panel with a chassis member in the plasma display device of Fig. 25;
Fig. 29 is a top plan view of a sheet piece which is a modification of the sheet piece of Fig. 26;
Fig. 30 is a side elevational view of the sheet piece of Fig. 29;
Fig. 31 is a top plan view of a sheet piece which is another modification of the sheet piece of Fig. 26; and
Fig. 32 is a side elevational view of the sheet piece of Fig. 31.

Before the description of the present invention proceeds, it is to be noted that like parts are designated by like reference numerals throughout several views of the accompanying drawings.

### DETAILED DESCRIPTION OF THE INVENTION

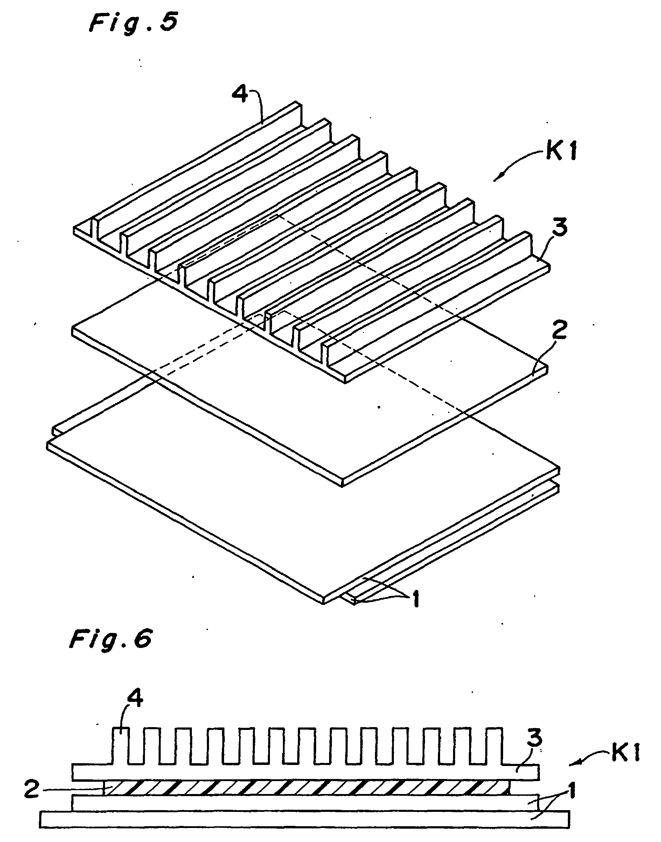

Referring now to the drawings, Figs. 5 and 6 show a plasma display device K1 . The plasma display device K1 includes a plasma display panel 1, a thermally conductive medium 2 and a chassis member 3 acting as a heat dissipating member. Projections 4 for effecting heat dissipation efficiently are provided on the chassis member 3. The thermally conductive medium 2 is adapted to not only lessen temperature difference in a plane of the plasma display panel 1 but lower temperature of the plasma display panel 1 by transferring heat of the plasma display panel 1 to the chassis member 3 efficiently and dissipating heat from the chassis member 3 into air. Meanwhile, if the thermally conductive medium 2 is made of soft material in gel state, the thermally conductive medium 2 acts also as a cushioning medium so as to protect the plasma display panel 1 from external impact.

A 26-inch type plasma display panel is used as the plasma display panel 1. The thermally conductive medium 2 having a thickness of 1 to 5 mm and formed by a silicone sheet in gel state and the chassis member 3 made of aluminum are sequentially attached to a whole rear face of the plasma display panel 1. When white display was performed on a whole face of the plasma display panel 1 by an electric power of 120 W, temperature of the plasma display panel 1 dropped about 25 °C in comparison with a case in which both the thermally conductive medium 2 and the chassis member 3 are not attached to the plasma display panel 1. The thermally conductive medium 2 may be formed by a rubber sheet in place of the silicone sheet.

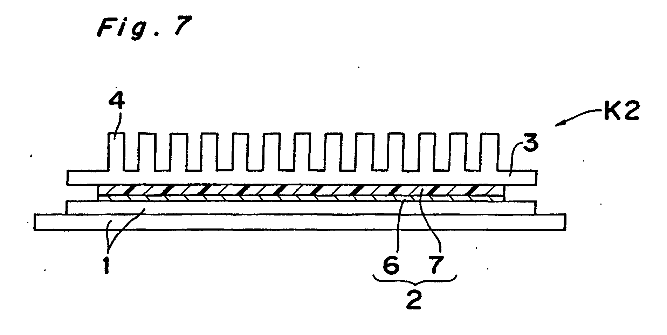

Meanwhile, since the plasma display panel 1 and the chassis member 3 have slight warpage, it is preferable that the thermally conductive medium 2 has higher flexibility so as to bring the thermally conductive medium 2 into close contact with the plasma display panel 1 and the chassis member 3 such that not only heat conduction from the plasma display panel 1 to the chassis member 3 is improved but the plasma display panel 1 is protected from external impact by the thermally conductive medium. In order to effectively reduce temperature difference in the plane of the plasma display panel 1 and lower temperature of the plasma display panel 1, the thermally conductive medium 2 has higher coefficient of thermal conductivity preferably. However, if material having a high coefficient of thermal conductivity is used for making the thermally conductive medium 2, content of metal in the material is high and thus, elasticity and flexibility of the thermally conductive medium 2 drop. Thus, in Fig. 7 showing a plasma display device K2 , the thermally conductive medium 2 has a two-layer construction including first and second mediums 6 and 7. The first medium 6 is formed by a metal sheet or a carbon sheet having a high coefficient of thermal conductivity, while the second medium 7 is formed by a flexible silicone sheet in gel state or the like having a standard coefficient of thermal conductivity. Flexibility is imparted to the first medium 6 by reducing thickness of the first medium 6 to 0.1 to 0.5 mm. Temperature difference in the plane of the plasma display panel 1, which is caused by heat produced in the plasma display panel 1, is lessened by the first medium 6. Heat transferred to the first medium 6 is transferred to the chassis member 3 by the second medium 7 efficiently and then, is dissipated from the chassis member 3 into air. Meanwhile, since the thermally conductive medium 2 has elasticity, vibrations and impact applied from outside to the plasma display panel 1 are mitigated by the thermally conductive medium 2, so that fracture of the plasma display panel 1 is prevented effectively and close contact of the thermally conductive medium 2 with the plasma display panel 1 and the chassis member 3 is enhanced and heat conduction from the plasma display panel 1 to the chassis member 3 is performed efficiently.

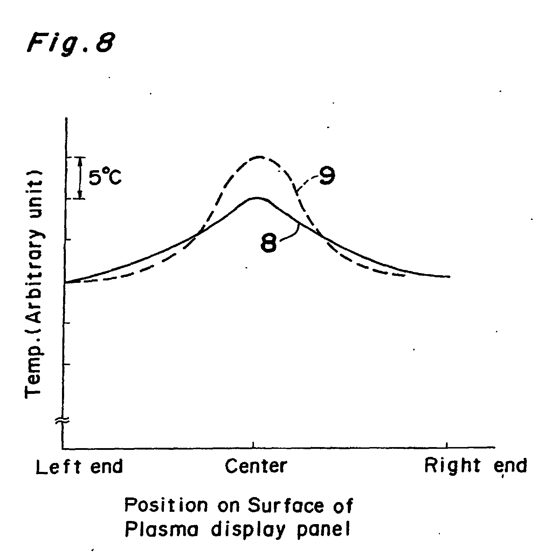

In the plasma display device K2, a carbon sheet having a coefficient of thermal conductivity of 800 to 1000 W/m°C and a thickness of 0.1 to 0.5 mm is employed as the first medium 6, while a silicone sheet in gel state, which has a coefficient of thermal conductivity of 1 to 5 W/m°C and a thickness of 1 to 5 mm, is employed as the second medium 7. By using this thermally conductive medium 2, a bright image is displayed at a central portion of the plasma display panel 1 against dark background as shown in Fig. 4. At this time, the solid line 8 in Fig. 8 shows characteristics of temperature distribution along the line X-X (Fig. 4) of the plasma display panel 1 of the plasma display device K2. On the other hand, the broken line 9 in Fig. 8 shows characteristics of temperature distribution along the line X-X of the plasma display panel 1 of the plasma display device K1. Heat in the plane of the plasma display panel 1 in the characteristics of the solid line 8 for the plasma display device K2 is diffused more sufficiently from the central portion of the plasma display panel 1 towards opposite end portions of the plasma display panel 1 than that in the characteristics of the broken line 9 for the plasma display device K1. As a result, temperature difference in the plane of the plasma display panel 1 of the plasma display device K2 is reduced conspicuously in comparison with that of the plasma display device K1. This is because the carbon sheet acting as the first medium 6 has the coefficient of thermal conductivity of 800 to 1000 W/m°C in a direction of its face. Although coefficient of thermal conductivity of the carbon sheet acting as the first medium 6 is lower in a direction of its thickness than in the direction of its face, heat is efficiently transferred in the direction of the thickness from the plasma display panel 1 to the chassis member 3 by making the carbon sheet thin as described above.

In the plasma display devices K2 and K1, since temperature difference in the plane of the plasma display panel 1 is less than 20 °C as is apparent from the lines 8 and 9 of Fig. 8, fracture of the plasma display panel 1 can be prevented.

The first medium 6 may be formed by a copper foil, an aluminum foil or the like in place of the carbon sheet, while the second medium 7 may be formed by a rubber sheet in place of the silicone sheet.

As is clear from the foregoing description of the plasma display panels K1 and K2, since the thermally conductive medium is provided between the plasma display panel and the chassis member, not only temperature of the plasma display panel in operation is lowered but temperature difference in the plane of the plasma display panel is lessened, so that the highly reliable plasma display device can be obtained. Furthermore, since the hitherto required draft fans are not employed, noise of motors of the draft fans is eliminated and electric power for driving the motors of the draft fans and space for mounting the motors of the draft fans are not necessary.

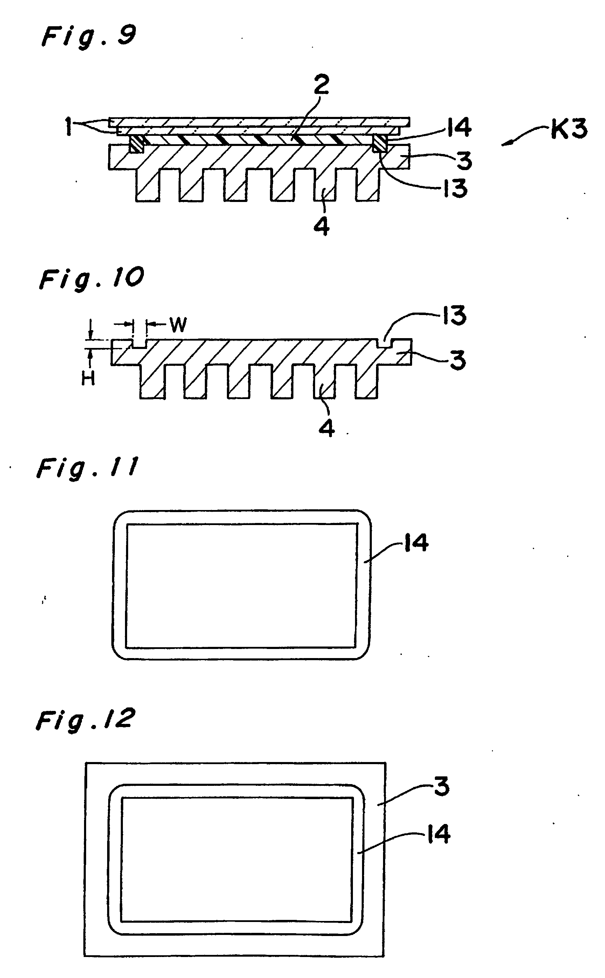

Fig. 9 shows a plasma display device K3 . In the plasma display device K3, a groove 13 is formed at a rectangular peripheral edge of the chassis member 3 and a cushioning medium 14 is fitted into the groove 13. The thermally conductive medium 2 is provided in a region enclosed by the cushioning medium 14 such that the cushioning medium 14 is brought into substantially close contact with the thermally conductive medium 2.

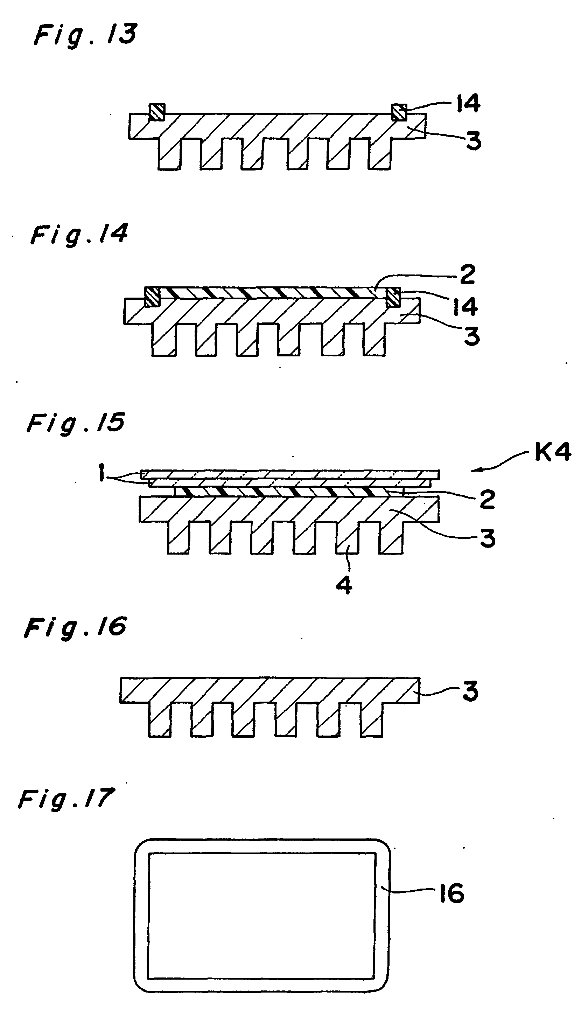

Hereinafter, a manufacturing method of the plasma display device K3 is described. As shown in Fig. 10, the groove 13 is formed at the rectangular peripheral edge of the chassis member 3 and has, for example, a width W of 5.5 mm and a depth H of 2 mm. The cushioning medium 14 having a rectangularly annular shape as shown in Fig. 11 is fitted into this groove 13 such that a predetermined region is enclosed by the cushioning medium 14 as shown in Figs. 12 and 13. For example, the cushioning medium 14 has a width of 5 mm and a height of 4 mm.

Subsequently, as shown in Fig. 14, paste of silicone resin is injected as the thermally conductive medium 2 into the region surrounded by the cushioning medium 14 and then, is cured. At this time, by setting atmosphere at a temperature of, for example, 120 °C, the paste of silicone resin is cured in about 20 min. so as to be turned into the solid thermally conductive medium 2. In this case, the cushioning medium 14 should have heat resistance. The paste of silicone resin can be dried at ordinary temperature but a long period is required for curing the paste of silicone resin at ordinary temperature.

The solid thermally conductive medium 2 obtained by curing the liquid silicone resin as described above has a thickness of 2 mm. By attaching the plasma display panel 1 to the thermally conductive medium 2, the plasma display device K3 is obtained.

The cushioning medium 14 may be formed by a silicone tape. In this case, after the liquid thermally conductive medium has been cured, the tape may be removed from the chassis member 3 or may be left as it is without being removed from the chassis member 3. Furthermore, in this case, the groove 13 is not required to be formed on the chassis member 3.

Meanwhile, in place of the cushioning member 14, a recess for receiving the thermally conductive medium 2 may be formed on one face of the chassis member 3, to which the thermally conductive medium 2 is attached or a frame for blocking outflow of the liquid thermally conductive medium may be merely provided on the face of the chassis member 3.

In the above described manufacturing method of the plasma display device K3, since bubbles do not penetrate in between the thermally conductive medium 2 and the chassis member 3, the plasma display device K3 having excellent heat conductivity and heat dissipation property can be obtained.

Fig. 15 shows a plasma display device K4. It should be noted that the plasma display device K4 is identical with the plasma display device K1. In the plasma display device K4, the thermally conductive medium 2 is provided on the chassis member 3 and the plasma display panel 1 is provided so as to be brought into substantially close contact with the thermally conductive medium 2.

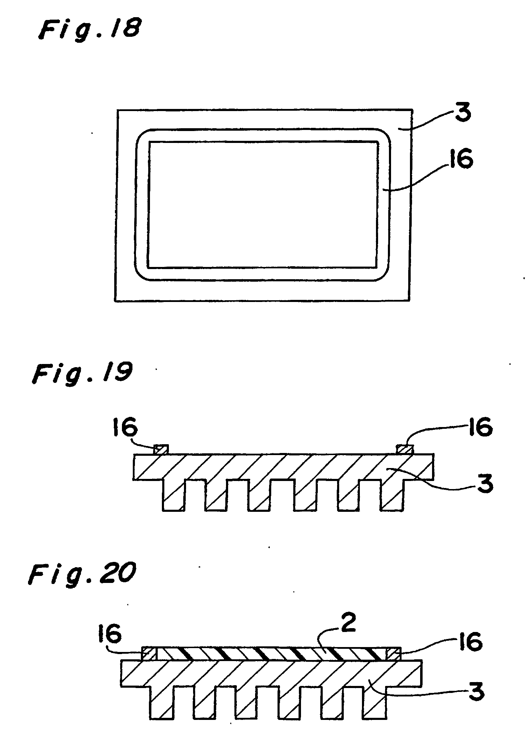

Hereinafter, a manufacturing method of the plasma display device K4 is described. A rectangularly annular frame mold 16 shown in Fig. 17 is secured to the chassis member 3 shown in Fig. 16 such that a region enclosed by the frame mold 16 is defined as shown in Figs. 18 and 19. For example, the frame mold 16 has a width of 5 mm and a height of 2 mm. Subsequently, as shown in Fig. 20, paste of the thermally conductive medium 2 is injected into the region enclosed by the frame mold 16 and then, is cured so as to obtain the solid thermally conductive medium 2. At this time, the thermally conductive medium 2 has a thickness of 1 to 5 mm, preferably, about 2 mm. Thereafter, the frame mold 16 is removed from the chassis member 3 and the plasma display panel 1 is attached to the thermally conductive medium 2. As a result, the plasma display device K4 is obtained.

In the manufacturing method of the plasma display device K4, since bubbles do not penetrate in between the thermally conductive medium 2 and the chassis member 3, the plasma display device K4 having excellent thermal conductivity and heat dissipation property can be obtained.

Meanwhile, in the above described plasma display panels K3 and K4, the thermally conductive medium 2 may be made of soft material in gel state, so that the thermally conductive medium 2 acts also as a cushioning medium so as to protect the plasma display panel 1 from external impact.

As is clear from the foregoing description of the plasma display panels K3 and K4, since the thermally conductive medium is provided between the plasma display panel and the chassis member, temperature of the plasma display panel in operation is lowered and thus, the highly reliable plasma display device can be obtained. Furthermore, in the manufacturing methods of the plasma display devices K3 and K4, it is possible to obtain the plasma display device having excellent heat conductivity and heat dissipation property, in which close contact of the thermally conductive medium with the plasma display panel and the chassis member is enhanced.

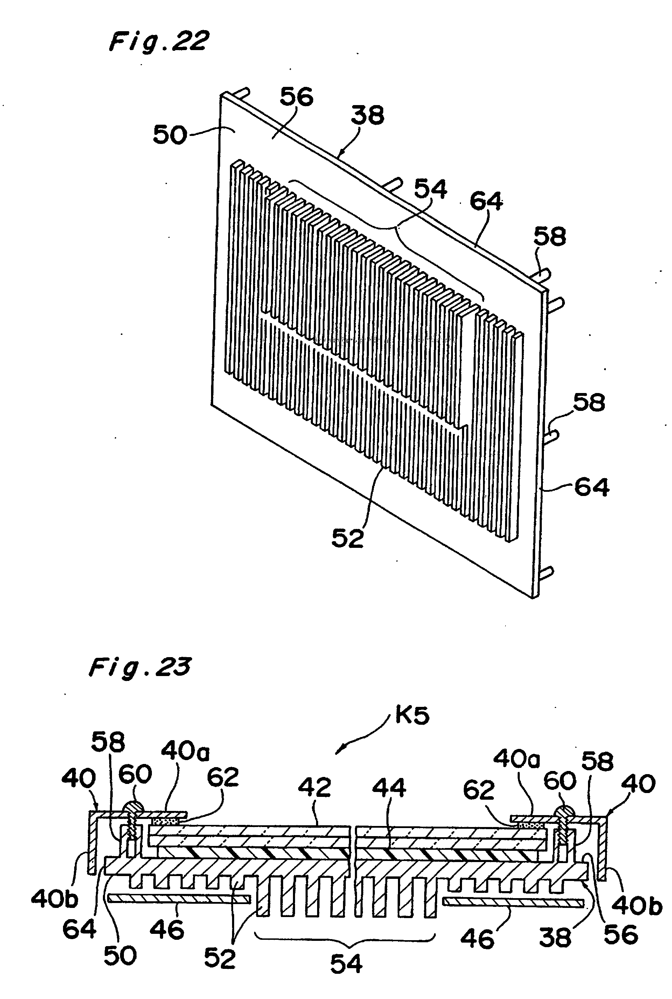

Fig. 21 shows a plasma display device K5 according to the present invention. The plasma display device K5 includes a casing 22 and an internal unit 36 accommodated in the casing 22. The casing 22 is formed by assembling a front casing 24 and a rear casing 26 with each other. A plurality of vent holes 28 and 30 are formed in a lateral direction of the arrow a at upper and lower portions of the front casing 24, respectively and a light transmitting portion 32 made of glass or the like is provided on a front face of the front casing 24. Likewise, a plurality of the vent holes 28 and 30 are formed in the lateral direction at upper and lower portions of the rear casing 26, respectively.

The internal unit 36 includes a chassis member 38, a plasma display panel 42 mounted on a front face 56 of the chassis member 38 by L-shaped angle plates 40, a thermally conductive medium 44 formed by a silicone sheet or the like and interposed between the chassis member 38 and the plasma display panel 42 and a plurality of circuit boards 46 supported on a rear face 50 of the chassis member 38. The thermally conductive medium 44 is provided for efficiently transferring heat of the plasma display panel 42 to the chassis member 38. Meanwhile, the circuit boards 46 are provided for driving and controlling light emission of the plasma display panel 42.

The plasma display panel 42 is constituted by a front panel and a rear panel. As will be seen from Fig. 5, the front panel has a lateral side longer than that of the rear panel and a vertical side shorter than that of the rear panel and thus, the front and rear panels have portions in which the front and rear panels do not overlap each other. Although not specifically shown, terminals connected to electrodes in the plasma display panel 42 are formed at these nonoverlapping portions of the front and rear panels. A plurality of filmy wires (not shown) each having a female connector at its distal end are contact bonded to the terminals. The female connectors are, respectively, connected to male connectors (not shown) provided at an edge of each of the circuit boards 46. Consequently, each of the circuit boards 46 is electrically connected to the plasma display panel 42.

The chassis member 38 is obtained by die casting of aluminum. As shown in 22, a plurality of fins 52 for heat dissipation are molded integrally with the chassis member 38 over a substantially whole area of the rear face 50 of the chassis member 38. The fins 52 each having a rectangular shape project from the rear face 50 of the chassis member 38 and extend vertically in parallel with each other so as to be laterally spaced a predetermined interval from each other. Experiments conducted by the inventors of this application revealed that when each of the fins 52 has a width of about 3 mm and a gap between the fins 52 is set at about 3 mm, namely, the fins 52 are arranged at an interval of about 6 mm, heat dissipation efficiency of the fins 52 is excellent. However, it is needless to say that the fins 52 are not restricted to these dimensions. In addition, the fins 52 are not restricted to the above mentioned shape but may also be vertically divided into a plurality of sections.

As shown in Fig. 22, the fins 52 at an upper central region 54 of the rear face 50 of the chassis member 38 are projected from the rear face 50 higher than the fins 52 at the remaining region of the rear face 50 of the chassis member 38 for the following reason. Namely, temperature of the chassis member 38 is raised by heat transferred from the plasma display panel 42 to the chassis member 38 via the thermally conductive medium 44. However, since temperature distribution of the chassis member 38 is not uniform and temperature of an upper portion of the chassis member 38 is inclined to be higher than that of the remaining portion of the chassis member 38. Therefore, on the basis of this finding, heat dissipation efficiency of the upper central region 54 of the rear face 50 of the chassis member 38 is made larger than that of the remaining region of the rear face 50 of the chassis member 38.

As shown in Fig. 21, the circuit boards 46 are disposed around the upper central region 54 of the rear face 50 of the chassis member 38. Hence, since the upper central region 54 of the rear face 50 of the chassis member 38 is not covered by the circuit boards 46, high heat dissipation efficiency of the fins 52 at the upper central region 54 of the rear face 50 of the chassis member 38 is not hampered by the circuit boards 46. Meanwhile, the circuit boards 46 are supported by studs (not shown) projecting from the rear face 50 of the chassis member 38 and are spaced away from a distal end of each of the fins 52 and the rear face 50 of the chassis member 38 so as not to be brought into contact with the fins 52 and the rear face 50 of the chassis member 38 directly as shown in Fig. 23.

On the other hand, a plurality of bosses 58 each having a threaded hole project integrally from a peripheral edge of the front face 56 of the chassis member 38. Since the bosses 58 are molded integrally with the chassis member 38 preliminarily, the number of operational steps and cost can be reduced in comparison with a case in which the bosses 58 are later mounted on the chassis member 38 by welding, crimping, etc.

The angle plates 40 are provided for four sides of the rectangular plasma display panel 42, respectively so as to clamp the plasma display panel 42 and the thermally conductive medium 44 to the chassis member 38 by screwing bolts 60 into the threaded holes of the bosses 58 through bolt holes of the angle plates 40 as shown in Figs. 21 and 23. Each of the angle plates 40 is formed by plate portions 40a and 40b intersecting with each other substantially orthogonally. The plate portion 40a is brought into pressing contact with a peripheral edge of a front face of the plasma display panel 42 through a cushioning member 62 made of foamed material such that the plasma display panel 42 is secured to the front face 56 of the chassis member 38 via the thermally conductive medium 44.

Meanwhile, the plate portion 40b of the angle plate 40 extends along each of four outer peripheral surfaces 64. A number of the above mentioned filmy wires (not shown) for electrically connecting the circuit boards 46 and the plasma display panel 42 are present between the plate portions 40b and the outer peripheral surfaces 64 of the chassis member 38. Therefore, when an operator mounts the assembled internal unit 36 in the rear casing 26 by gripping an edge of the assembled internal unit 36, the plate portions 40b serve to protect the filmy wires so as to prevent damage to the filmy wires.

In the plasma display device K5 of the above described arrangement, when display is performed by light emission of the plasma display panel 42, temperature of the plasma display panel 42 is raised by heat produced by electrical discharge in the plasma display panel 42. Heat produced in the plasma display panel 42 is transferred to the chassis member 38 through the thermally conductive medium 44 and is efficiently dissipated from the fins 52 molded integrally with the chassis member 38. Air heated in the casing 22 by this heat dissipation is discharged outwardly from the vent holes 28 of the upper portion of the casing 22, while air having room temperature flows into the casing 22 from the vent holes 30 of the lower portion of the casing 22. The plasma display panel 42 and the circuit boards 46 are cooled by this natural convection. On the supposition that a maximum room temperature is 40 °C, it was found by experiments conducted by the inventors of this application that temperature in the casing 22 can be maintained at not more than a permissible highest temperature which is equal to a sum of 40 °C and a room temperature.

Since the fins 52 are molded integrally with the chassis member 38 for supporting the plasma display panel 42 such that the chassis member 38 acts also as a heat dissipating member as described above, it is possible to obtain an unforced cooling construction in which air in the casing 22 is subjected to natural convection so as to cool interior of the casing 22. Therefore, since exhaust fans for forcedly discharging air in the casing 22 outwardly so as to forcedly cool interior of the casing 22 are not required to be provided, such problems as noise and failure of the exhaust fans and suction of dust due to forced exhaust can be eliminated and production cost can be reduced.

Meanwhile, in the plasma display device K5, the unforced cooling construction in which the exhaust fans are eliminated is employed as described above. However, in the plasma display device K5, the exhaust fan may also be provided as an auxiliary for natural convection of air so as to promote flow of air in the casing 22. In this case, since the number of the installed exhaust fans can be reduced in comparison with prior art plasma display devices, the above described drawbacks of the prior art plasma display devices can be mitigated.

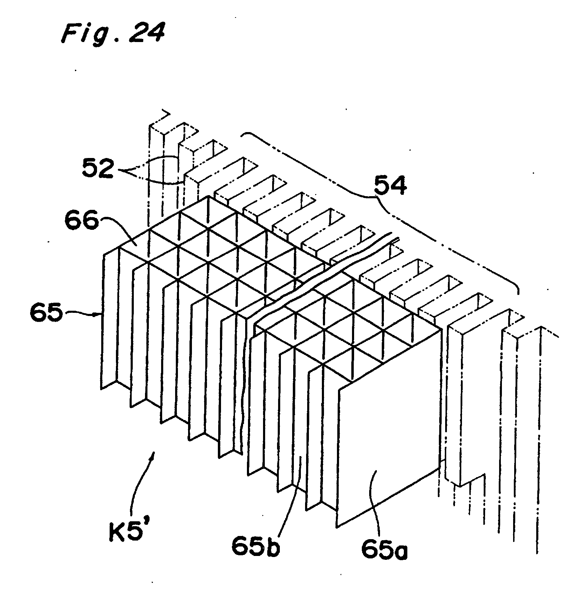

Fig. 24 shows a plasma display device K5' which is a modification of the plasma display device K5. In the plasma display device K5', an auxiliary heat dissipating member 65 is additionally provided on the fins 52 at the upper central region 54 of the rear face 50 of the chassis member 38 so as to further raise heat dissipation efficiency of the fins 52 at the upper central region 54 of the chassis member 38. The auxiliary heat dissipating member 65 is formed by a metal plate 65a bent into a substantially U-shaped configuration and a metal plate assembly 65b having a checked pattern and fixed to inside of the metal plate 65a. A plurality of square space regions 66 are defined in the auxiliary heat dissipating member 65 so as to extend vertically in the same manner as the fins 52. Each of the space regions 66 is not restricted to the square shape but may have any other shape. Experiments conducted by the inventors of this application showed that if the auxiliary heat dissipating member 65 is provided, temperature of the chassis member 38 further drops 10 °C as compared with a case in which the auxiliary heat dissipating member 65 is not provided. Therefore, in the case of a plasma display device employing a DC type plasma display panel, in which quantity of heat produced in the DC plasma display panel is larger than that of an AC type plasma display panel, it is especially preferable that the auxiliary heat dissipating member 65 is additionally provided.

Meanwhile, in Fig. 24, the auxiliary heat dissipating member 65 is provided on the fins 52 at the upper central region 54 of the rear face 50 of the chassis member 38. However, it may also be so arranged that the fins 52 at the upper central region 54 of the rear face 50 of the chassis member 38 is set to have a height identical with that of the fins 52 at the remaining region of the rear face 50 of the chassis member 38, namely, all the fins 52 on the rear face 50 of the chassis member 38 have an identical height and then, the auxiliary heat dissipating member 65 is provided on the fins 52 at the upper central region 54 of the chassis member 38 so as to raise heat dissipation efficiency of the fins 52 at the upper central region 54 of the rear face 50 of the chassis member 38.

As is clear from the foregoing description of the present invention, heat transferred from the plasma display panel to the chassis member can be dissipated efficiently by the fins molded integrally with the chassis member. Air in the casing, which has been heated by this heat dissipation, is discharged outwardly from the vent holes of the upper portion of the casing and air having room temperature flows into the casing from the vent holes of the lower portion of the casing such that natural convection of air happens. Consequently, the plasma display panel and the circuit boards are cooled and thus, temperature in the casing can be maintained at not more than the permissible highest temperature.

Since the chassis member for supporting the plasma display panel acts also as a heat dissipating plate having high heat dissipation efficiency, the unforced cooling construction in which interior of the casing is cooled by natural convection of air is employed, so that exhaust fans are not required to be provided. Therefore, such drawbacks as noise and failure of the exhaust fans and suction of dust due to forced exhaust can be obviated and production cost can be lowered. Meanwhile, also when the exhaust fan is used as an auxiliary for natural convection of air, the number of the installed exhaust fans can be reduced in comparison with prior art plasma display devices, the above mentioned disadvantages of the prior art plasma display devices can be eliminated and production cost can be reduced.

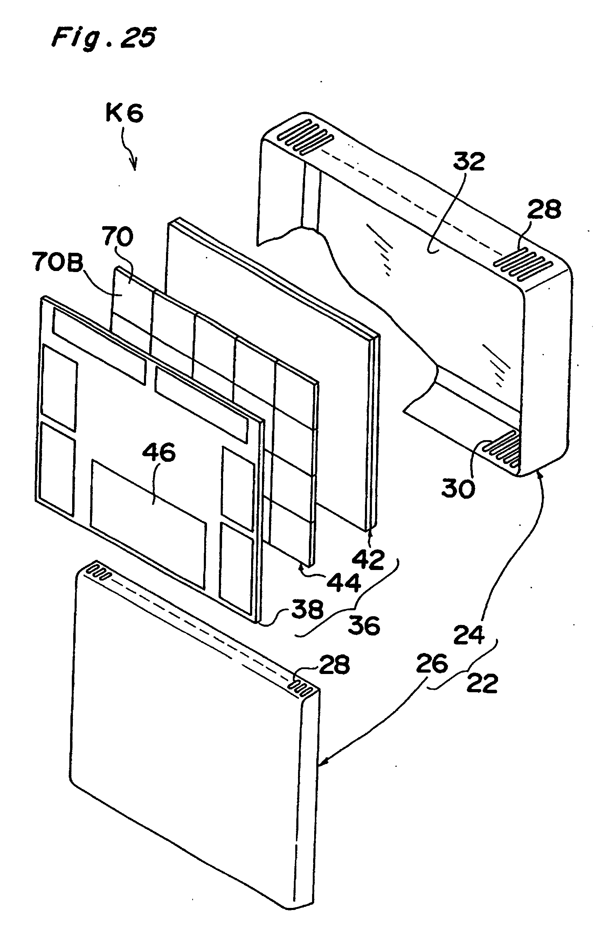

Fig. 25 shows a plasma display device K6 according to an embodiment of the present invention. In the same manner as the plasma display device K5, the plasma display device K6 includes the casing 22 and the internal unit 36. The thermally conductive medium 44 of the internal unit 36 is formed by a sheet made of material having excellent thermal conductivity and flexibility, for example, silicone resin and not only serves to efficiently transfer to the chassis member 38 heat produced in the plasma display panel 42 but acts also as a cushioning medium. As shown in Fig. 25, the thermally conductive medium 44 has a size substantially equal to that of the plasma display panel 42. Meanwhile, the thermally conductive medium 44 is formed by arranging a plurality of sheet pieces 70 in a checked pattern without any gap therebetween.

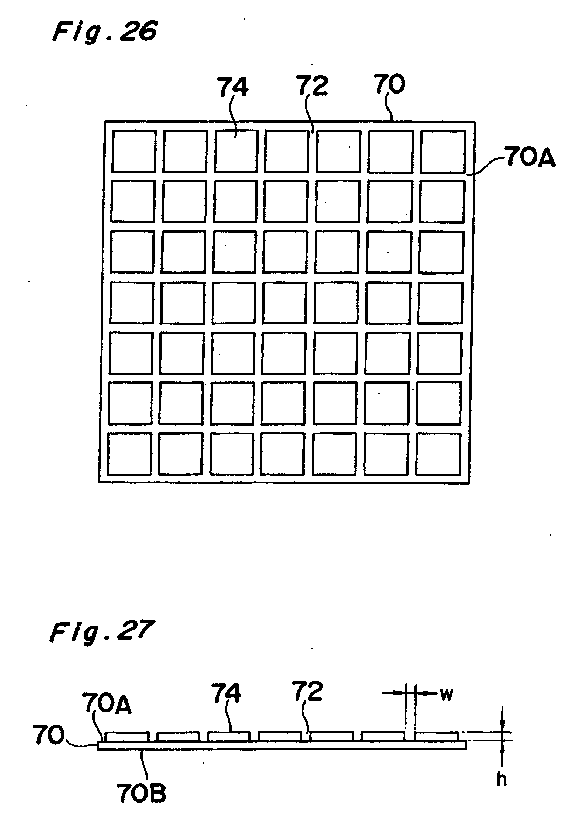

Figs. 26 and 27 show the sheet piece 70 having opposite faces 70A and 70B confronting the plasma display panel 42 and the chassis member 38, respectively. A plurality of protrusions 74 are formed in a shape of a matrix on the face 70A of the sheet piece 70 such that a checked slit 72 is defined between the protrusions 74. The sheet piece 70 is of a square shape having a side of 100 mm in length and has a thickness of 2 mm. The protrusion 74 is of a square shape having a side of 13 mm in length and has a height h of 1 mm, while the slit 72 has a width w of 2 mm. However, these shapes and dimensions are not restrictive but may be changed variously.

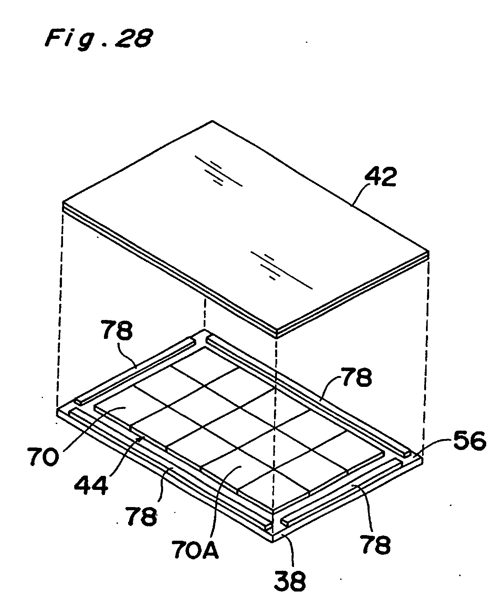

The plasma display panel 42 is assembled with the chassis member 38 as shown in Fig. 28. Initially, four double sided adhesive tapes 78 each having a thickness substantially equal to that of the thermally conductive medium 44 are bonded to four outer peripheral edges of the front face 56 of the chassis member 38, respectively. Then, the thermally conductive medium 44 formed by the arranged sheet pieces 70 is placed on the front face 56 of the chassis member 38 such that the face 70A of each of the sheet pieces 70, i.e., the protrusions 74 of each of the sheet pieces 70 confront the plasma display panel 42. Subsequently, air present between the chassis member 38 and the thermally conductive medium 44 is completely pushed out by using a roller or the like such that the thermally conductive medium 44 is brought into close contact with the chassis member 38. Since opposite faces of the thermally conductive medium 44 have stickiness, air does not penetrate in between the chassis member 38 and the thermally conductive medium 44 once the thermally conductive medium 44 has been brought into close contact with the chassis member 38.

Thereafter, the plasma display panel 42 is placed on the double sided adhesive tapes 78 and the thermally conductive medium 44 and is depressed lightly against the double sided adhesive tapes 78 and the thermally conductive medium 44 from above with a hand. As a result, the plasma display panel 42 is brought into pressing contact with the protrusions 74 of each of the sheet pieces 70 of the thermally conductive medium 44, so that the square protrusions 74 are crushed so as to expand sidewise. The slit 72 of each of the sheet pieces 70 acts as an air discharge passage in the course of this expansion of the protrusions 74 so as to discharge air outwardly and is finally occupied by the expanding protrusions 74 so as to vanish. Consequently, since air layer between the thermally conductive medium 44 and the plasma display panel 42 is eliminated substantially completely, the thermally conductive medium 44 and the plasma display panel 42 are brought into close contact with each other and the plasma display panel 42 is secured to the chassis member 38 by the double sided adhesive tapes 78. Since the plasma display panel 42 is not transparent, it is impossible to observe process of discharge of air. However, it was confirmed by an experiment that when a transparent glass plate is brought into pressing contact with the thermally conductive medium 44, the glass plate is brought into close contact with the thermally conductive medium 44 without formation of air layer therebetween.

Meanwhile, even if air layer remains in the slits 72 when the plasma display panel 42 has been depressed against the thermally conductive medium 44, the plasma display panel 42 as a whole can be brought into contact with the thermally conductive medium 44 substantially uniformly and thus, air layer remains substantially uniformly between the thermally conductive medium 44 and the plasma display panel 42. Therefore, thermal conductivity is improved and uniformed over a whole area of the plasma display panel 42 in comparison with a case in which air layer remains locally between the thermally conductive medium 44 and the plasma display panel 42.

In the plasma display device K6, the protrusions 74 and the slits 72 are provided on one face of the thermally conductive medium 44 and the plasma display panel 42 is placed on and depressed lightly against the face of the thermally conductive medium 44 so as to outwardly discharge air present between the thermally conductive medium 44 and the plasma display panel 42 as described above. Therefore, since the thermally conductive medium 44 and the plasma display panel 42 can be brought into close contact with each other easily, thermal conductivity can be uniformed over the whole area of the plasma display panel 42.

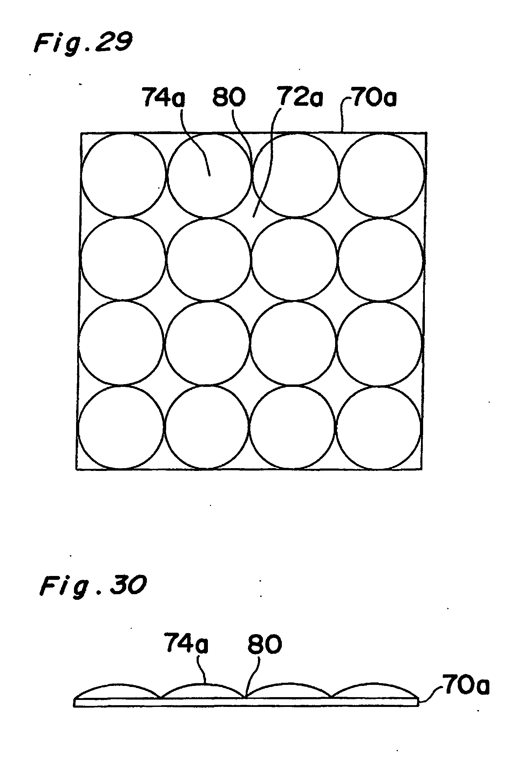

Figs. 29 and 30 show a sheet piece 70a which is a modification of the sheet piece 70 of Fig. 26. In the sheet piece 70a, a plurality of circular protrusions 74a are arranged so as to be brought into contact with each other. As shown in Fig. 30, each of the protrusions 74a has a convex surface such that its thickness decreases gradually from its central portion towards its outer periphery. Boundaries 80 between the protrusions 74a and areas 72a in which the protrusions 74a are not present correspond to the slit 72 of the sheet piece 70. The sheet piece 70a can achieve effects similar to those of the sheet piece 70.

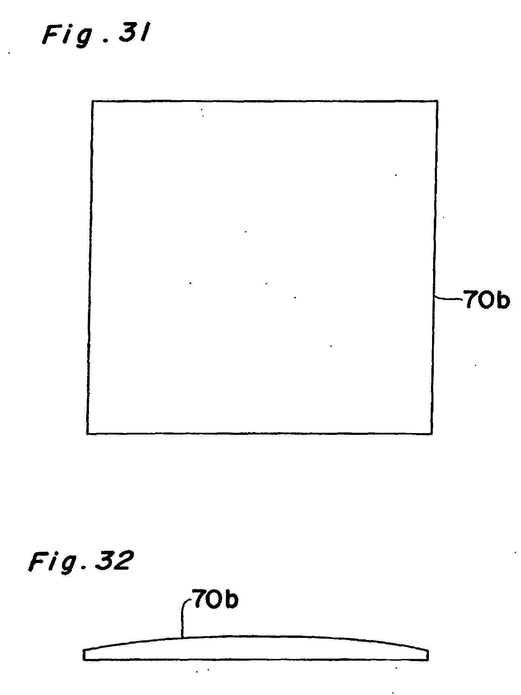

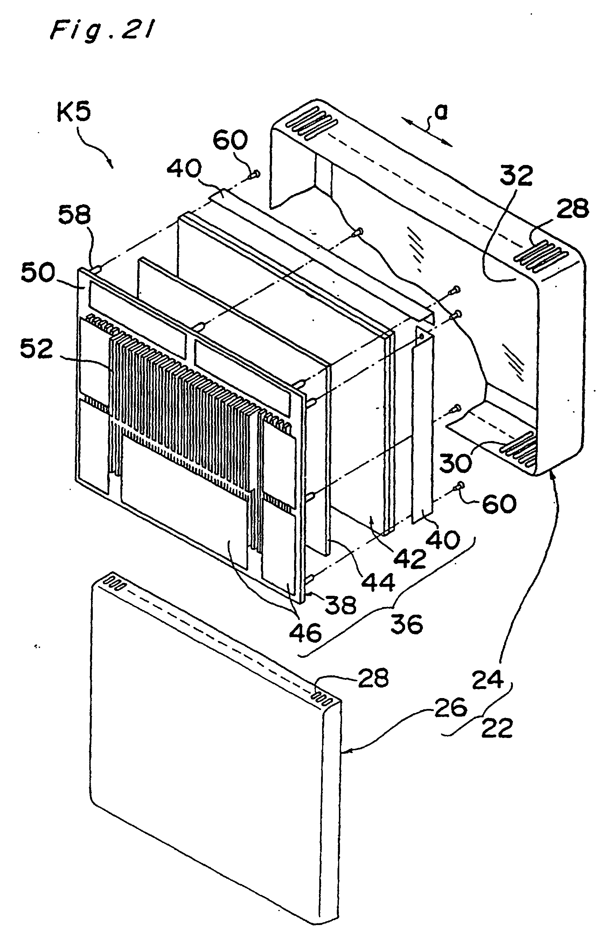

Meanwhile, Figs. 31 and 32 show a sheet piece 70b which is another modification of the sheet piece 70. The sheet piece 70b has a convex surface such that its thickness decreases gradually from its central portion towards its outer periphery. Therefore, when the thermally conductive medium 44 is formed by arranging the sheet pieces 70b, the central portion of the sheet piece 70b acts as the protrusions 74 of the sheet piece 70, while the outer periphery of the sheet piece 70b acts as the slit 72 of the sheet piece 70. Accordingly, the thermally conductive medium 44 formed by the sheet pieces 70b can gain effects similar to those of the thermally conductive medium 44 formed by the sheet pieces 70.

The protrusions 74 and the slits 72 are formed on one face of the thermally conductive medium 44 but may also be formed on opposite faces of the thermally conductive medium 44. Meanwhile, the thermally conductive medium 44 is formed by arranging a plurality of the sheet pieces 70, 70a or 70b but may also be formed by a single sheet of a size substantially equal to that of the plasma display panel 42 and having protrusions and a slit which produce effects of the protrusions 74 and the slit 72, respectively.

As is clear from the foregoing description of the embodiment K6 of the present invention, the protrusions and the slits are provided on one face of the thermally conductive medium and the plasma display panel is placed on the face of the thermally conductive medium and is depressed lightly against the face of the thermally conductive medium with a hand so as to outwardly discharge air present between the thermally conductive medium and the plasma display panel. Therefore, in the embodiment K6 of the present invention, since the plasma display panel and the thermally conductive medium can be easily brought into close contact with each other without a large quantity of air remaining between the plasma display panel and the thermally conductive medium, thermal conductivity can be uniformed over the whole area of the plasma display panel.

## Claims

1. A plasma display device **characterized by**:
an internal unit (36) which includes a chassis member (38) and a plasma display panel (42) mounted on a front face (56) of the chassis member (38);
a thermally conductive sheet (44) which is interposed between the chassis member (38) and the plasma display panel (42);
a circuit board (46) for driving light emission of the plasma display panel (42), which is provided on a rear face (50) of the chassis member (38); and
a casing (22) for accommodating the internal unit (36) and is constituted by a front casing (24) and a rear casing (26);
wherein the rear casing (26) is formed with a plurality of vent holes (28).

2. A plasma display as claimed in claim 1,
wherein a double sided adhesive tape (78) is provided for attaching the plasma display panel (42) to a front face (56) of the chassis member (38); and
wherein the chassis member (38) and the plasma display panel (42) are secured by the double sided adhesive tape (78) and the thermally conductive sheet (44) is brought into close contact with the chassis member (38) and the plasma display panel (42).

3. A plasma display device as claimed in claim 1 or 2,
wherein the thermally conductive sheet (44) is formed by a flexible material; and
wherein the plasma display panel (42) and the thermally conductive sheet (44) are brought into close contact with each other.

4. A plasma display device as claimed in claim 3,
wherein an uneven portion formed by a protrusion (74) and a recess (72) is provided on one face (70A) of the thermally conductive sheet (44) brought into contact with the plasma display panel (42);
wherein the protrusion (74) is adapted to be crushed so as to expand sidewise, when the plasma display panel (42) is brought into pressing contact with the face of the thermally conductive sheet (44); and
wherein the slit (72) acts as an air passage in the course of expansion of the protrusion (74) so as to discharge air on the face of the thermally conductive sheet (44) outwardly.

5. A plasma display device as claimed in claim 1 or 2,
wherein the thermally conductive sheet (44) has a two-layer construction including a first thermally conductive sheet (6) brought into substantially close contact with the plasma display panel (1) and a second thermally conductive sheet (7) brought into substantially close contact with the frame chassis (3);
wherein the first thermally conductive sheet (6) has a higher coefficient of thermal conductivity than the second thermally conductive sheet (7), while the second thermally conductive sheet (7) is so elastic as to function as a cushioning medium.

6. A plasma display device as claimed in claim 5,
wherein the thermally conductive sheet (44) has a thickness of 0.1 to 0.5 mm.

7. A plasma display device as claimed in claim 5,
wherein the thermally conductive sheet (44) has a coefficient of thermal conductivity of 800 to 1000 W/m°C and a thickness of 0.1 to 0.5 mm.

8. A plasma display device as claimed in claim 1,
wherein the thermally conductive sheet (44) has a coefficient of thermal conductivity of 1 to 5 W/m°C and a thickness of 1 to 5 mm.

9. A plasma display device as claimed in claim 1 or 2,
wherein a plurality of heat dissipating fins (52) is provided on the rear face (50) of the chassis member (38).

## Patentansprüche

1. Plasmabildschirmvorrichtung, **gekennzeichnet durch**:
eine interne Einheit (36), welche ein Chassiselement (38) und eine Plasmabildschirmplatte (42), welche an einer Frontseite (56) des Chassiselements (38) befestigt ist, beinhaltet;
eine thermisch leitende Lage (44), welche zwischen das Chassiselement (38) und die Plasmabildschirmplatte (42) eingesetzt ist;
eine Schaltungsplatte (46) zum Betreiben der Lichtemission der Plasmabildschirmplatte (42), wobei die Schaltungsplatte (46) auf einer Rückseite (50) des Chassiselements (38) bereitgestellt ist; und
ein Gehäuse (22) zum Aufnehmen der internen Einheit (36), bestehend aus einem Frontgehäuse (24) und einem Rückgehäuse (26);
worin das Rückgehäuse (26) mit einer Vielzahl von Belüftungslöchern (28) ausgebildet ist.

2. Plasmabildschirm nach Anspruch 1,
wobei ein doppelseitiges Klebeband (78) bereitgestellt ist zum Befestigen der Plasmabildschirmplatte (42) an einer Frontseite (56) des Chassiselements (38); und
wobei das Chassiselement (38) und die Plasmabildschirmplatte (42) durch das doppelseitige Klebeband (78) befestigt sind und die thermisch leitende Lage (44) in nahen Kontakt mit dem Chassiselement (38) und der Plasmabildschirmplatte (42) gebracht ist.

3. Plasmabildschirmvorrichtung nach Anspruch 1 oder 2,
wobei die thermisch leitende Lage (44) aus einem flexiblen Material ausgebildet ist; und
wobei die Plasmabildschirmplatte (42) und die thermisch leitende Lage (44) in nahen Kontakt zueinander gebracht sind.

4. Plasmabildschirmvorrichtung nach Anspruch 3,
wobei ein unebener Abschnitt, welcher aus einem Vorsprung (74) und einer Vertiefung (72) gebildet ist, auf einer Seite (70A) der thermisch leitenden Lage (44), welche in Kontakt mit der Plasmabildschirmplatte (42) gebracht ist, bereitgestellt ist;
wobei der Vorsprung (74) ausgebildet ist, um gebrochen zu werden und so sich seitwärts auszuweiten, wenn die Plasmabildschirmplatte (42) in Presskontakt mit der Vorderseite der thermisch leitenden Lage (44) gebracht wird; und
wobei der Schlitz (72) als ein Luftdurchgang bei dem Vorgang der Ausweitung des Vorsprungs (74) wirkt, um so Luft auf der Vorderseite der thermisch leitenden Lage (44) nach auswärts abzuführen.

5. Plasmabildschirmvorrichtung nach Anspruch 1 oder 2,
wobei die thermisch leitende Lage (44) eine Zweischichtkonstruktion aufweist, beinhaltend eine erste thermisch leitende Lage (6,) welche in im wesentlichen nahen Kontakt mit der Plasmabildschirmplatte (1) gebracht ist, und eine zweite thermisch leitende Lage (7,) welche in im wesentlichen nahen Kontakt mit dem Chassisrahmen (3) gebracht ist;
wobei die erste thermisch leitende Lage (6) einen höheren Wärmeleitkoeffizienten aufweist als die zweite thermisch leitende Lage (7), während die zweite thermisch leitende Lage (7) so elastisch ist, dass sie als ein Puffermedium wirkt.

6. Plasmabildschirmvorrichtung nach Anspruch 5,
wobei die erste thermisch leitende Lage (6) eine Dicke von 0,1 bis 0,5 mm aufweist.

7. Plasmabildschirmvorrichtung nach Anspruch 5,
wobei die erste thermisch leitende Lage (6) einen Wärmeleitkoeffizient von 800 bis 1000 W/m°C und eine Dicke von 0,1 bis 0,5 mm aufweist.

8. Plasmabildschirmvorrichtung nach Anspruch 1,
wobei die thermisch leitende Lage (44) einen Wärmeleitkoeffizient von 1 bis 5 W/m°C und eine Dicke von 1 bis 5 mm aufweist.

9. Plasmabildschirmvorrichtungen nach Anspruch 1 oder 2,
wobei eine Vielzahl von hitzeabstrahlenden Rippen (52) auf der Rückseite (50) des Chassiselements (38) bereitgestellt ist.

## Revendications

1. Dispositif d'affichage au plasma **caractérisé par** :
une unité interne (36) qui inclut un élément de châssis (38) et un panneau d'affichage au plasma (42) monté sur une face avant (56) de l'élément de châssis (38) ;
une feuille thermiquement conductrice (44) qui est interposée entre l'élément de châssis (38) et le panneau d'affichage au plasma (42) ;
une carte de circuit (48) pour entraîner l'émission de lumière du panneau d'affichage au plasma (42), qui est disposé sur une face arrière (50) de l'élément de châssis (38) ; et un coffret (22) pour recevoir l'unité interne (36) et qui est constitué d'un coffret avant (24) et d'un coffret arrière (26) ;
dans lequel le coffret arrière (26) est formé avec une pluralité de trous de ventilation (28).

2. Affichage au plasma selon la revendication 1,
dans lequel une bande adhésive double face (78) est prévue pour fixer le panneau d'affichage au plasma (42) à une face avant (56) de l'élément de châssis (38) ;
et
dans lequel l'élément de châssis (38) et le panneau d'affichage au plasma (42) sont fixés par la bande adhésive double face (78) et la feuille thermiquement conductrice (44) est amenée en contact rapproché avec l'élément de châssis (38) et le panneau d'affichage au plasma (42).

3. Dispositif d'affichage au plasma selon la revendication 1 ou 2,
dans lequel la feuille thermiquement conductrice (44) est formée par un matériau flexible ;
et
dans lequel le panneau d'affichage au plasma (42) et la feuille thermiquement conductrice (44) sont amenés en contact rapproché l'un avec l'autre.

4. Dispositif d'affichage au plasma selon la revendication 3,
dans lequel une partie irrégulière formée par une protubérance (74) et un évidement (72) est disposé sur une face (70A) de la feuille thermiquement conductrice (44) amenée en contact avec le panneau d'affichage au plasma (42) ;
dans lequel la protubérance (74) est conçue pour être écrasée de façon à se dilater dans le sens latéral, lorsque le panneau d'affichage au plasma (42) est amené en contact de pression avec la face de la feuille thermiquement conductrice (44) ; et
dans lequel la fente (72) agit comme passage d'air au cours de la dilatation de la protubérance (74) de façon à évacuer l'air vers l'extérieur présent sur la face de la feuille thermiquement conductrice (44).

5. Dispositif d'affichage au plasma selon la revendication 1 ou 2,
dans lequel la feuille thermiquement conductrice (44) a une structure à deux couches incluant une première feuille thermiquement conductrice (6) amenée en contact sensiblement rapproché avec le panneau d'affichage au plasma (1) et une seconde feuille thermiquement conductrice (7) amenée sensiblement en contact rapproché avec le cadre du châssis (3)
dans lequel la première feuille thermiquement conductrice (6) présente un coefficient de conductivité thermique plus élevé que celui de la seconde feuille thermiquement conductrice (7), tandis que la seconde feuille thermiquement conductrice (7) est élastique de manière telle qu'elle peut agir comme support d'amortissement.

6. Dispositif d'affichage au plasma selon la revendication 5,
dans lequel la première feuille thermiquement conductrice (6) présente une épaisseur de 0,1 à 0,5 mm.

7. Dispositif d'affichage au plasma selon la revendication 5,
dans lequel la première feuille thermiquement conductrice (6) présente un coefficient de conductivité thermique de 800 à 1 000 W/m° C et une épaisseur de 0,1 à 0,5 mm.

8. Dispositif d'affichage au plasma selon la revendication 1,
dans lequel la feuille thermiquement conductrice (44) présente un coefficient de conductivité thermique de 1 à 5 W/m° C et une épaisseur de 1 à 5 mm.

9. Dispositif d'affichage au plasma selon la revendication 1 ou 2,
dans lequel une pluralité d'ailettes de dissipation thermique (52) sont disposées sur la face arrière (50) de l'élément de châssis (38).
